# EUROPEAN PATENT APPLICATION

(11) **EP 0 746 024 A2**
(43) Date of publication of application: **04.12.1996**
(21) Application number: 96303618.1
(22) Date of filing: 21.05.1996
(51) Int. Cl.: H01L 23/485

(54) **Semiconductor device with built-in AC coupling circuitry**

(30) Priority: 30.05.1995 US 454049
(71) Applicant: AT&T Corp., New York, NY 10013-2412 (US)
(72) Inventor: Gabara, Thaddeus John, Murray Hill, New Jersey 07974 (US)
(74) Representative: Johnston, Kenneth Graham

(57) **Abstract**

I have recognized that a bonding pad of a semiconductor device may be used as part of an impedance means for reducing an undesirable component of a signal. The semiconductor device also has a semiconductor substrate to which the impedance means is coupled. The semiconductor substrate has a plurality of semiconductor elements therein. In one embodiment, the impedance means is a capacitor, the bonding pad serves as a first conductive plate of the capacitor, and the undesirable component is a direct current component of the signal. The semiconductor device facilitates communications with another semiconductor device without using a large, discrete impedance means (e.g., a discrete capacitor).

## Description

### Field Of The Invention

The present invention relates to semiconductor devices and electrical couplings therebetween.

### Background Of The Invention

Electronic devices including but not limited to data communication circuits, televisions, stereos, computers, military devices, and facsimile machines are prevalent in today's world. Each electronic device has number of semiconductor devices.

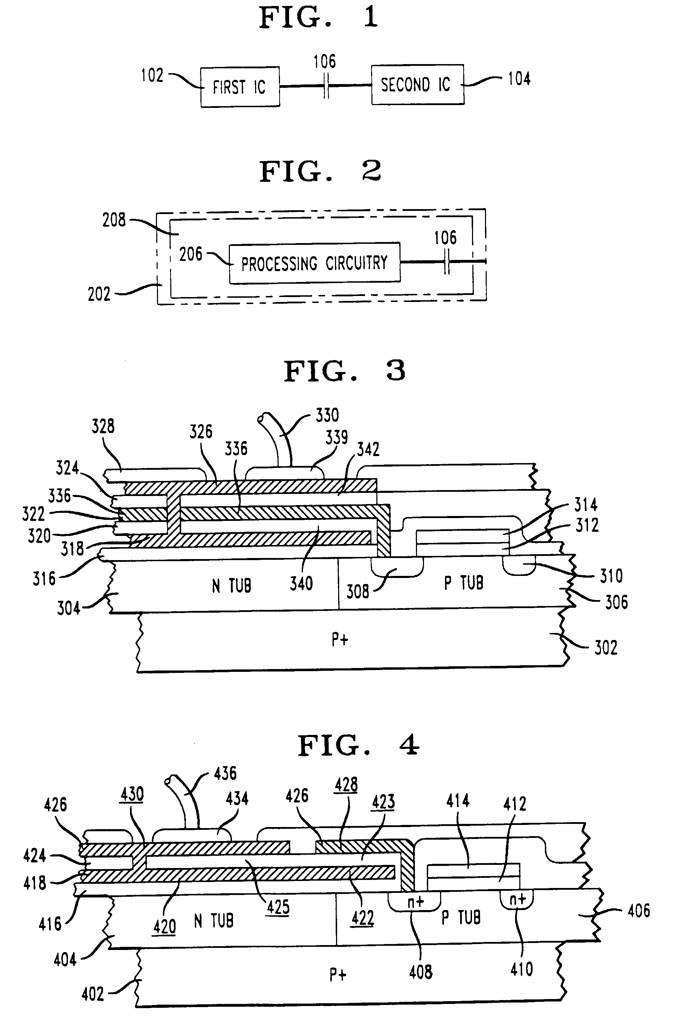

In some electronic devices, most notably electronic devices comprising data communication circuits, a first semiconductor device is coupled to a second semiconductor device. As used herein, a semiconducor device is a monolithic structure with a plurality of active devices. However, a semiconductor device does not include other parts of an integrated circuit ("IC") such as a housing. Thus, the IC has a semiconductor device and a housing. As used herein, the housing shall mean the structure of an IC that is used to package and communicate with the semiconductor device. The terms semiconductor device and IC chip (but not IC) are used synonymously herein. The second semiconductor device may receive and process a signal from the first semiconductor device. Preferably, the signal contains only an AC component (as opposed to both AC and undesirable DC components). In this situation, the first semiconductor device is said to be AC coupled to the second semiconductor device. AC coupling advantageously requires less power than other types of coupling (e.g., AC and DC). Also, AC coupling advantageously leads to communications which are independent of DC biasing. It is well known, as shown in Figure 1, to interpose a discrete capacitor 106 between a first IC 102 (housing the first semiconductor device) and a second IC 104 (housing the second semiconductor device) to achieve AC coupling and thus eliminate the impact of the undesirable DC component.

### Summary Of The Invention

I have recognized that a bonding pad of a semiconductor device may be used as part of an impedance means for reducing an undesirable component of a signal. The semiconductor device also has a semiconductor substrate to which the impedance means is coupled. The semiconductor substrate has a plurality of semiconductor elements therein. In one embodiment, the impedance means is a capacitor, the bonding pad serves as a first conductive plate of the capacitor, and the undesirable component of the signal is a direct current component.

Advantageously, the semiconductor device facilitates communications with another semiconductor device without using a large, discrete impedance means (e.g., a discrete capacitor).

Also advantageously, the semiconductor device may be combined with a housing for the semiconductor device to form an IC.

Other advantages of the present invention will become apparent from the remainder of the specificafion.

### Brief Description Of The Drawings

Figure 1 shows a prior art technique for AC coupling the first semiconductor device to the second semiconductor device;
Figure 2 shows general components of an IC made in accordance with the present invention.
Figure 3 shows a partial cross sectional view of a first illustrative embodiment of an integrated circuit chip made in accordance with the present invention; and
Figure 4 shows a partial cross sectional view of a second illustrative embodiment of an integrated circuit chip made in accordance with the present invention.

### Detailed Description

### INTRODUCTION:

Prior to discussing some embodiments of the present invention, it should be noted that the structures depicted will be readily fabricated by those skilled in the art using known techniques. Such techniques may be used to deposit and pattern conductive and dielectric layers. For example, well known lithographic, ion implantation, etching, etc., processes may be used. Thus, detailed description of such processes is unnecessary. The details of the electronics within the ICs will vary depending upon the intended application of the IC.

Although many different structures may be used to form the present invention as will be appreciated by those skilled in the art, for illustrative purposes, two embodiments of the present invention will be described. Each of the two embodiments uses a different structure for the capacitor which acts as the impedance means. The first type of capacitor, which will be described later with reference to Figure 3, comprises a first conductive plate ohmically coupled to an element from the plurality of elements, a dielectric layer comprising a capacitive portion disposed above at least a portion of the first conductive plate, and a bonding pad serving as a second conductive plate. As used herein, the term ohmically coupled means a non-open coupling that may be measured in ohms. Examples of items that may be used to provide ohmic couplings are wires and resistors. Thus, measures of impedance that are frequency dependent do not indicate an ohmic coupling. Further, as used herein, element A will be considered to be "above" element B if element A is further than element B from the semiconductor substrate regardless of whether element A actually contacts element B. Additionally, with respect to Figure 3, the "capacitive portion" of a dielectric layer refers to that portion of the dielectric layer that is interposed between at least a portion of the bonding pad and at least a portion of another plate of a capacitor. At least a portion of the bonding pad is disposed above the capacitive portion of the dielectric layer. Other items shown in Figure 3 will be discussed later in more detail. The second type of capacitor, as shown in Figure 4, comprises a first conductive plate comprising a bonding pad portion and a capacitive portion, a dielectric layer comprising a first portion and a second portion, a bonding pad, and a second conductive plate. The first portion is disposed above at least a portion of the capacitive portion and the second portion is disposed above at least a portion of the bonding pad portion. The bonding pad is ohmically coupled to the first conductive plate. At least a portion of the bonding pad is disposed above the second portion. The second conductive plate is ohmically coupled to an element from the plurality of elements. At least a portion of the second conductive plate is disposed above the first portion.

### ILLUSTRATIVE EMBODIMENTS:

Referring to Figure 2, an IC 202 is shown. The IC comprises a capacitor 204 and processing circuitry 206. As used herein, "processing circuitry" means any circuitry that stores (e.g., memory) data, manipulates data, and/or is involved in data communications. The processing circuitry may be implemented with e.g., 0.5 or 0.9 micrometer Complementary Metal Oxide Semiconductor ("CMOS") technology. It should be noted that the invention is independent of: (1) the type of IC 202 (e.g., data communications IC) with which it is used; (2) the technology (e.g., CMOS) with which it is used; and (3) the size (e.g., 0.5 micrometers) of the technology with which it is used.

Again referring to Figure 2, both the capacitor 204 and the processing circuitry 206 are within an IC chip 208 associated with the IC 202. In addition to the IC chip 208, the IC comprises a housing, a mentioned above. The housing has a communications port means for communicating with the semiconductor device. The communications port means is coupled to the bonding pad. As used herein, a "communications port" shall mean any medium through which a signal may enter or leave an IC chip 208. An example of such a medium is a bonding wire.

Referring to Figure 3, a portion of a first embodiment of the present invention may be realized on the IC chip 208 (not shown) using 0.5 micrometer CMOS technology. The IC chip 208 employs a p+ substrate 302 approximately 500 micrometers thick. As will be appreciated by those skilled in the art, the p+ substrate 302 includes a p-epi layer (not shown). An n-tub portion 304 and a p-tub portion 306 are formed in the p+ substrate 302. The p-tub 306 has a first n+ region 308 and a second n+ region 310 formed within it. The n-tub portion 304 and the p-tub portion 306 are approximately 5 micrometers thick while the first n+ region 308 and the second n+ region 310 are less than 0.4 micrometers thick. the p+ substrate 302, the n-tub 304, the p-tub 306, first n+ region 308, and the second n+ region 310 will be collectively referred to as a semiconductor substrate 311. Thus, the first n+ region 308 and the second n+ region 310 are a plurality of semiconductor elements within the semiconductor substrate 311. An n+ substrate could also be used provided that other appropriate changes apparent to those skilled in the art would be made.

Again referring to Figure 3, a thin oxide layer 312 (approximately 90 angstroms thick) bridges the first n+ region 308 and the second n+ region 310 of the substrate 311. A layer of polysilicon 314 (approximately 2,000 angstroms thick) is formed over the thin oxide layer 312. A dielectric layer 316 is then formed over the exposed existing structures. The dielectric layer 316, which is about 5,000 angstroms thick, has windows to allow for connection to various semiconductor devices such as the first n+ region 308 and the second n+ region 310. Although "window" and "via" will be used interchangeably herein, generally a "window" refers to a structure that facilitates the coupling of a portion of the IC chip 208 to an active device within the substrate whereas a "via" refers to a structure that facilitates the coupling of a portion of the IC chip to another portion of the IC chip, typically excluding the substrate. A first conductive plate 318 (approximately 5,000 angstroms thick) is formed having vias where appropriate. A second dielectric layer 320 (approximately 7,000 angstroms thick) is formed having vias where appropriate. Those skilled in the art will appreciate that, as with other layers, the vias are formed after the layer is formed. A second conductive plate 322 (also approximately 5,000 angstroms thick) is formed having vias where appropriate. The second conductive plate 322 is connected to the first n+ region 308 through appropriate windows. A third dielectric layer 324 (also approximately 7,000 angstroms thick) is also formed having vias where appropriate. A third conductive plate 326 (approximately 7,000 angstroms thick) is formed. The third conductive plate 326 is connected to the first conductive plate 318 through appropriate vias. As will be apparent to those skilled in the art, the via shown coupling the third conductive plate 326 to the first conductive plate 318 is not ohmically coupled to the second conductive plate 322. Thus, as shown in Figure 3, the via may be thought of as being in front of the second conductive plate 322. A fourth dielectric layer 328 (approximately 3.3 micrometers thick) is formed having vias where appropriate. The fourth dielectric layer comprises an oxide layer covered by a layer of SiN. A via approximately 100 micrometers by 100 micrometers is shown to expose the third conductive plate.

The thicknesses mentioned above with respect to Figure 3 are preferable thicknesses. However, the range of thickness for some of the elements are as follows: the thin oxide layer 312 from about 80 angstroms to about 100 angstroms; the layer of polysilicon 314 from about 1,850 angstroms to about 2,550 angstroms; the dielectric layer 316 from about 4,250 angstroms to about 5,750 angstroms; the first conductive plate 318 from about 4,900 angstroms to about 6,400 angstroms; the second dielectric layer 320 from about 5,500 angstroms to about 8,500 angstroms; the second conductive plate 322 from about 4,900 angstroms to about 6,400 angstroms; the third dielectric layer 324 from about 5,500 angstroms to about 8,500 angstroms; the third conductive plate 326 from about 6,150 angstroms to about 8,150 angstroms; and the fourth dielectric layer 328 from about 29,800 angstroms to about 36,200 angstroms.

Again referring to Figure 3, the exposed area of the third conductive plate 326 allows for a first end 329 of a bonding wire 330 to be attached to the third conductive plate 326. A second end (not shown) of the bonding wire 330 is coupled to a pin lead of the IC 202. Thus, the bonding wire 330 allows for the transmission and/or reception of signals to and/or from the pin lead to the IC chip 208.

In some instances, the force with which the first end 329 of the bonding wire 330 is connected to the exposed area of the third conductive plate 326 may cause problems such as the third conductive plate 326 becoming short circuited with the second conductive plate 322. If the yield is decreased for a particular process and/or application to an unacceptable level (e.g., below 90 percent), it may prove advantageous to use an alternative design that will now be described with reference to Figure 4.

Referring to Figure 4, a portion of a second embodiment of the present invention may be realized on the IC chip 208 using 0.9 micrometer CMOS technology. The IC chip 208 employs a p+ substrate 402 approximately 500 micrometers thick. As will be appreciated by those skilled in the art, the p+ substrate 402 includes a p-epi layer (not shown). An n-tub portion 404 and a p-tub portion 406 are formed in the p+ substrate 402. The p-tub 406 has a first n+ region 408 and a second n+ region 410 formed within it. The n-tub portion 404 and the stub portion 406 are approximately 2 micrometers thick while the first n+ region 408 and the second n+ region 410 are approximately 0.4 micrometers thick. The p+ substrate 402, the n-tub 404, the p-tub 406, first n+ region 408, and the second n+ region 410 will be collectively referred to as a semiconductor substrate 411.

Again referring to Figure 4, a thin oxide layer 412 (approximately 125 angstroms thick) bridges the first n+ region 408 and the second n+ region 410 of the substrate 411. A layer of polysilicon 414 (approximately 3,000 angstroms thick) is formed over the thin oxide layer 412 that is approximately 4,000 angstroms thick. A dielectric layer 416, also approximately 5,000 angstroms thick, is then formed over the exposed existing structures. The dielectric layer 416 has windows to allow for connection to various semiconductor devices such as the first n+ region 408 and the second n+ region 410. A first conductive plate 418 (approximately 5,000 angstroms thick) is formed and has windows where appropriate. The first conductive plate may be thought of as having two areas, namely a bonding pad area 420 and a capacitive area 422. A second dielectric layer 424 (approximately 9,000 angstroms thick) is formed having windows where appropriate. The second dielectric layer has a first portion 423 and a second portion 425. The first portion 423 is disposed above at least a portion of the capacitive area 422 and the second portion 425 is disposed above at least a portion of the bonding pad area 420. A second conductive plate 426 (also approximately 10,000 angstroms thick) is formed having vias where appropriate. The second conductive plate 426 has a first portion 428 and a second portion 430 that are not ohmically connected. Thus, with respect to Figure 4, the terms "second portion 430" of the second conductive plate 426 and "bonding pad 430" are used synonymously. In fact, the first portion 428 of the second conductive plate 426 is formed over at least a portion of the capacitive area 422 of the first conductive plate 418. Additionally, the first portion 428 is connected to the first n+ region 408 through appropriate windows. The second portion 430 of the second conductive plate 426 is formed over at least a portion of the bonding pad area 420 of the first conductive plate. The second portion 430 is ohmically connected to the bonding pad area 420 by a via.

Still referring to Figure 4, a third dielectric layer 432 (also approximately 14,000 angstroms thick) is also formed having vias where appropriate. A via, approximately 100 micrometers by 100 micrometers, is shown to expose the second portion 430 of the second conductive plate 426. This allows for connection of a first end 434 of a bonding wire 436 to the IC chip 208. A second end (not shown) of the bonding wire 436 is coupled to a pin lead of IC 202. Thus, the bonding wire 436 allows for the transmission and/or reception of signals to and/or from the pin lead to the IC chip 208.

The thicknesses mentioned above with respect to Figure 4 are preferable thicknesses. However, the range of thickness for some of the elements are as follows: the thin oxide layer 412 from about 110 angstroms to about 140 angstroms; the layer of polysilicon 414 from about 2,300 ansgtroms to about 3,200 angstroms; the dielectric layer 416 from about 4,950 angstroms to about 6,050 angstroms; the first conductive plate 418 from about 4,500 angstroms to about 5,500 angstroms; the second dielectric layer 424 from about 8,345 angstroms to about 9,655 angstroms; the second conductive plate 426 from about 9,000 angstroms to about 11,000 angstroms; and the third dielectric layer 432 from about 11,000 angstroms to about 17,000 angstroms.

The invention has been described with respect to two embodiments. However, those skilled in the art will realize that there are many other variations and modifications that may be made to the present invention. For example, the present invention may be packaged as an integrated circuit as mentioned above. Further, although the present invention has been described within a CMOS environment, the invention may be implemented with other types of IC technologies such as NMOS, BiCMOS, GaAs, bipolar, bulk CMOS and others well known to those skilled in the art. Those skilled in the art will realize that the semiconductor substrate may have different structures depending upon the technology in which the invention is implemented. For example, in the NMOS technology, the semiconductor substrate 311 would not need a n tub (e.g., 304 of Figure 3 and 404 of Figure 4). Thus, the term semiconductor substrate as defined above was only illustratively defined with respect to Figures 3 and 4. Additionally, although each plate of the capacitor has been described as being a metal plate, those skilled in the art will realize that other structures (e.g., the layer of polysilicon 314) may be used to form one of the conductive plates of the capacitor. Further, although Figures 3 and 4 show the impedance means being coupled to a device formed in the p tub portion of the semiconductor substrate, they could be coupled to a device formed in the n tub portion of the semiconductor substrate in addition to or in lieu of the coupling to the device formed in the p tub portion of the semiconductor substrate. Still further, the impedance means could be coupled to any other structure in the IC chip, including the semiconductor substrate. Further, if a manufacturer is concerned about the force with which a, e.g., bonding wire is attached to a bonding pad, the manufacturer may use the embodiment shown in Figure 2 and place the bonding pad on an extra oxide layer which rests upon, e.g., the third conductive plate 326. The extra oxide layer would help absorb the force with which the bonding wire is attached to the bonding pad. Also,the bonding pad would be shorted to the third conductive plate 326 and be disposed above (but not "on") a capacitive portion of the third dielectric layer 324. Thus, the invention is defined by the appended claims.

## Claims

1. A semiconductor device comprising:
(a) a semiconductor substrate having a plurality of semiconductor elements therein; and
(b) impedance means for reducing an undesirable component of a signal, said impedance means being coupled to said semiconductor substrate, said impedance means comprising a bonding pad.

2. The semiconductor device of claim 1 wherein said impedance means comprises a capacitor and said bonding pad serves as a first conductive plate of said capacitor.

3. The semiconductor device of claim 2 wherein said undesirable component is a direct current component of said signal.

4. An integrated circuit comprising:
(a) a semiconductor device comprising:
(1) a semiconductor substrate having a plurality of semiconductor elements therein; and
(2) impedance means for reducing an undesirable component of a signal, said impedance means being coupled to said semiconductor substrate, said impedance means comprising a bonding pad; and
(b) housing means for packaging said semiconductor device, said housing means comprising a communications port means for communicating with said semiconductor device, said communications port means being coupled to said bonding pad.

5. The semiconductor device of claim 4 wherein said impedance means comprises a capacitor and said bonding pad serves as a first conductive plate of said capacitor.

6. The semiconductor device of claim 5 wherein said undesirable component is a direct current component of said signal.

7. A semiconductor device comprising:
(a) a semiconductor substrate having a plurality of semiconductor elements therein;
(b) a capacitor coupled to said semiconductor substrate, said capacitor comprising:
(1) a first conductive plate ohmically coupled to an element from said plurality of semiconductor elements;
(2) a dielectric layer comprising a capacitive portion disposed above at least a portion of said first conductive plate; and
(3) a bonding pad serving as a second conductive plate, at least a portion of said bonding pad being disposed above said capacitive portion of said dielectric layer.

8. The semiconductor device of claim 7 wherein said first conductive plate is ohmically coupled to said element by a short circuit.

9. A semiconductor device comprising:
(a) a semiconductor substrate having a plurality of semiconductor elements therein;
(b) a capacitor coupled to said semiconductor substrate, said capacitor comprising:
(1) a first conductive plate comprising a bonding pad area and a capacitive area;
(2) a dielectric layer comprising a first portion and a second portion, said first portion being disposed above at least a portion of said capacitive area and said second portion being disposed above at least a portion of said bonding pad area;
(3) a bonding pad ohmically coupled to said first conductive plate, at least a portion of said bonding pad being disposed above at least a portion of said second portion; and
(4) a second conductive plate ohmically coupled to an element from said plurality of semiconductor elements, at least a portion of said second conductive plate being disposed above at least a portion of said first portion.

10. The semiconductor device of claim 9 wherein said first conductive plate is ohmically coupled to said bonding pad by a short circuit and wherein said second conductive plate is ohmically coupled to said element by a short circuit.

11. An integrated circuit comprising:
(a) semiconductor device comprising a semiconductor substrate having a plurality of semiconductor elements therein and a capacitor coupled to said semiconductor substrate, said capacitor comprising:
(1) a first conductive plate ohmically coupled to an element from said plurality of semiconductor elements;
(2) a dielectric layer comprising a capacitive portion disposed above at least a portion of said first conductive plate; and
(3) a bonding pad serving as a second conductive plate, at least a portion of said bonding pad being disposed above said capacitive portion of said dielectric layer; and
(b) housing means for packaging said semiconductor device, said housing means comprising a communications port means for communicating with said semiconductor device, said communications port means being coupled to said bonding pad.

12. The integrated circuit of claim 11 wherein said means for holding comprises a plastic package.

13. The integrated circuit of claim 11 wherein said first conductive plate is ohmically coupled to said element by a short circuit.

14. An integrated circuit comprising:
(a) a semiconductor device comprising a semiconductor substrate having a plurality of semiconductor elements therein and a capacitor coupled to said semiconductor substrate, said capacitor comprising:
(1) a first conductive plate comprising a bonding pad area and a capacitive area;
(2) a dielectric layer comprising a first portion and a second portion, said first portion being disposed above at least a portion of said capacitive area and said second portion being disposed above at least a portion of said bonding pad area;
(3) a bonding pad ohmically coupled to said first conductive plate, at least a portion of said bonding pad being disposed above at least a portion of said second portion; and
(4) a second conductive plate ohmically coupled to an element from said plurality of semiconductor elements, at least a portion of said second conductive plate being disposed above at least a portion of said first portion; and
(b) housing means for packaging said semiconductor device, said housing means comprising a communications port means for communicating with said semiconductor device, said communications port means being coupled to said bonding pad.

15. The integrated circuit of claim 14 wherein said first conductive plate is ohmically coupled to said bonding pad by a short circuit and wherein said second conductive plate is ohmically coupled to said element by a short circuit.
